# EUROPÄISCHE PATENTSCHRIFT

(11) **EP 1 292 994 B1**
(45) Veröffentlichungstag und Bekanntmachung des Hinweises auf die Patenterteilung: **15.09.2004**
(21) Anmeldenummer: 01931410.3
(22) Anmeldetag: 05.04.2001
(51) Int. Cl.: H01L 41/053

(54) **PIEZOAKTOR**
PIEZO ACTUATOR
ACTIONNEUR PIEZO-ELECTRIQUE

(30) Priorität: 25.05.2000 DE 10025997
(43) Veröffentlichungstag der Anmeldung: 19.03.2003
(73) Patentinhaber: ROBERT BOSCH GMBH, 70442 Stuttgart (DE)
(72) Erfinder: HEINZ, Rudolf, 71272 Renningen (DE); HEDRICH, Alexander, 70499 Stuttgart (DE); BOECKING, Friedrich, 70499 Stuttgart (DE)
(86) Internationale Anmeldenummer: PCT/DE2001/001329
(87) Internationale Veröffentlichungsnummer: WO 2001/091197

(56) Entgegenhaltungen:
- WO-A-92/06532
- DE-A- 3 844 134
- DE-A- 19 914 411
- US-A- 4 553 059

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Beispielsweise ist aus der DE 196 50 900 ein piezoelektrischer Aktor bekannt, der insbesondere zur Betätigung von Steuerventilen oder Einspritzventilen in Kraftfahrzeugen geeignet ist. Hierzu besteht dieser aus in Form eines Laminats aufeinander geschichteten Lagen piezoelektrischen Materials und dazwischen liegenden metallischen bzw. elektrisch leitenden, als Elektroden dienenden Schichten. Der so gebildete Aktorkörper, an dessen Endflächen je eine ventilseitige Kopfplatte mit einem axial herausragenden Ventilstößel und eine gegenüberliegende Fußplatte angebracht sind, wird in eine Haltebohrung eines Ventilgehäuses eingesetzt. Stirnseitig ist der Aktorkörper zwischen der Kopfplatte und der Fußplatte durch ein Federelement in axialer Richtung vorgespannt.

Wie eingangs erwähnt, führen derartige piezoelektrische Mehrlagenaktoren, wenn sie mit einer pulsierenden elektrischen Spannung an ihren Elektrodenschichten beaufschlagt werden, analog pulsierende Hübe unter Änderung des Abstandes zwischen ihren beiden Stirnseiten aus. Der piezoelektrische Mehrlagenaktor muss dabei im Stahlgehäuse des Einspritzventils so gelagert sein, daß keine Kurzschlüsse entstehen, so dass ein zentrierter Einbau mit definiertem Abstand zur Außenwand gewährleistet sein muss und keine Gefahr von Kurzschlüssen zwischen dem Aktorkörper und der Außenwand besteht.

Beim Betrieb solcher piezoelektrischer Mehrlagenaktoren entsteht im Aktorkörper Wärme, die, um Zerstörungen und Beeinträchtigungen der Funktion des Mehrlagenaktors zu vermeiden, nach außen, d.h. hier zum Ventilgehäuse des Einspritz- oder Steuerventils abgeführt werden muss. Beim zuvor erwähnten bekannten Mehrlagenaktor nimmt die Federhülse die vom Aktorkörper erzeugte Wärme auf, führt sie nach außen ab und sorgt gleichzeitig für die zur Isolation notwendige Zentrierung des Aktorkörpers im Ventilgehäuse. Für sich gesehen ist aus der DE 197 15 488 Cl auch noch bekannt, dass ein Aktorkörper mit einer Polymerumhüllung umgeben ist, die allerdings zwischen sich und der Innenwand des Ventilgehäuses einen Luftspalt offen lässt. Dadurch entsteht der Nachteil, daß die Wärmeabfuhr zum Ventilgehäuse durch den Luftspalt erschwert wird.

### Vorteile der Erfindung

Beim erfindungsgemäßen Piezoaktor wird davon ausgegangen, dass ein Piezoelement vorhanden ist, das zur Beaufschlagung eines Betätigungselements mit einer Zug- oder Druckkraft geeignet ist und mit einem Fußteil versehen ist, an dem das Piezoelement befestigt und über die das Piezoelement unter einer mechanischen Vorspannung in einem Gehäuse zentriert gehalten ist. In vorteilhafter Weise ist gemäß des Kennzeichens des Hauptanspruchs am Fußteil eine Hülse befestigt, die das Piezoelement zumindest in Teilbereichen, elektrisch von diesem isoliert, mechanisch stabilisierend umschließt.

Besonders vorteilhaft ist es, wenn zwischen die Hülse und das Piezoelement ein wärmeleitendes Elastomer eingebracht ist und die Hülse aus einem wärmeleitfähigen und in vorgegebenen Grenzen verformbaren Material besteht. Diese Baugruppe mit dem Piezoelement und der Hülse an dem Fußteil kann nun auf einfache Weise in eine Haltebohrung des Gehäuses eingepresst werden, so dass sich eine gute Wärmeleitung vom piezoelektrischen Mehrlagenaktor beispielsweise zu einem Ventilgehäuse ergibt. Das Fußteil kann dabei auch eine umlaufende Nut aufweisen, in die ein ebenfalls umlaufender Wulst am Innendurchmesser der Hülse einklinkbar ist.

Mit der Hülse hat der Piezoaktor eine unempfindliche Oberfläche, z.B. gegenüber chemischen Einflüssen, und kann einfach montiert werden und ein solches Aktormodul ist auch gegen schädliche Beeinträchtigungen beim Transport und bei der Montage geschützt. Der in der Hülse vergossene Piezoaktor ist durch das Elastomer zentriert und gegen verdrehen gesichert, da der Kraftfluss nicht nur über das Fußteil sondern zusätzlich über das Elastomer auf die ebenfalls mit dem Fußteil verbundene Hülse erfolgt.

Gegenüber einem ohne Hülse nur mit wärmeleitfähigen Elastomer ummantelten piezoelektrischen Piezoaktor ist auch der Herstellungsprozeß kostengünstiger, da die notwendige Pflege der Vergußformen entfällt. Die Montage des erfindungsgemäßen Piezoaktors ist auch dadurch einfacher, da es nicht wie bei einem nur mit Elastomer ummantelten piezoelektrischen Piezoaktor zu Verletzungen der Ummantelung und damit verbundenem Austrag von Wärmeleitpartikeln und folglich zu einer Verschmutzung der Haltebohrung kommen kann.

Die erfindungsgemäße, in der Regel dünnwandige Hülse aus dem wärmeleitfähigem und deformierbarem Material, z.B. Kupfer, Stahl oder einem Kunststoff, ist fest mit dem Fußteil des Piezoelements verbunden und kann dabei zur Verbesserung der Zentrierung nach oben hin einen leicht zunehmenden Außendurchmesser aufweisen. Eine Hülse aus Metall ist beispielsweise kostengünstig als gerolltes Bauteil aus Stanzblech herstellbar. Eine Hülse aus Kunststoff, z.B. als Spritzgussteil, darf dabei das Piezoelement berühren und dadurch dem Aktormodul auch ohne Elastomerummantelung mehr Stabilität verleihen.

Gemäß einer weiteren Ausführungsform ist es vorteilhaft, wenn durch zusätzlich in die Hülse eingelegte, vorzugsweise ein Hohlprofil aufweisende Zentrierringe das Piezoelement noch besser in der Hülse zentriert werden kann und gleichzeitig ein Raum für den Wärme- und Einpressdehnungsausgleich geschaffen wird.

Auch kann durch eine schräge Schulter in der Haltebohrung auf einfache Weise eine kalibrierende Einpressung der Hülse ermöglicht und damit eine enge Anlage der Hülse zur Haltebohrung gewährleistet werden, wodurch eine sehr gute Wärmeleitung radial nach außen erfolgt.

Bei einer anderen Ausführungsform des erfindungsgemäßen Piezoaktors ist die Hülse gelocht oder geschlitzt, so dass das wärmeleitfähige Elastomer durch diese Hülse hindurch fließen kann und direkt die Wärmeleitung zwischen dem Piezoelement und dem Gehäuse mit der Haltebohrung herstellt. Der Verguss des Piezoelements kann sowohl im Gehäuse als auch außerhalb in einer wiederverwendbaren oder verlorenen Form erfolgen.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ausführungsbeispiele des erfindungsgemäßen Piezoaktors, beispielsweise für ein Kraftstoffeinspritzsystem in einem Kraftfahrzeug, werden anhand der Zeichnung erläutert. Es zeigen:
Figur 1 einen Schnitt durch einen Piezoaktor mit einer Hülse und einer Elastomerschicht;
Figuren 3 bis 5 einen Detailschnitt des Fußteils mit unterschiedlichen Befestigungsmöglichkeiten des Fußteils am Piezoelement;
Figur 6 einen Schnitt durch einen Piezoaktor mit einer Hülse mit Löchern als Ausnehmungen;
Figur 7 eine Detailansicht der Hülse nach der Figur 6;
Figur 8 einen Schnitt durch einen Piezoaktor mit einer Hülse mit Längsschlitzen als Ausnehmungen und
Figur 9 einen Detailschnitt des Fußteils mit einer weiteren Befestigungsmöglichkeit am Piezoelement.

### Beschreibung der Ausführungsbeispiele

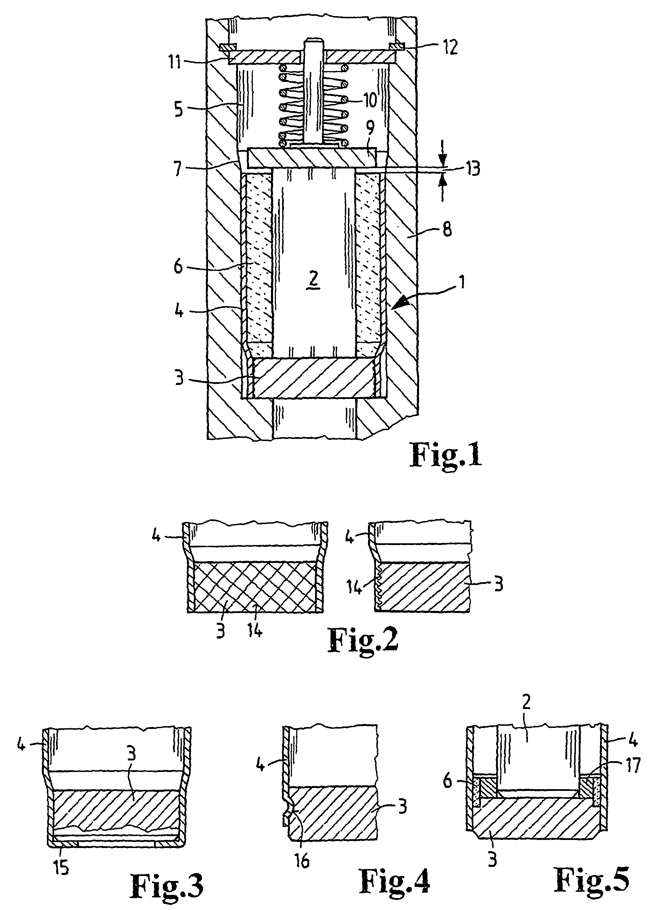

In Figur 1 ist ein Piezoaktor 1 als piezoelektrischer Mehrlagenaktor gezeigt, der ein Piezoelement 2 aufweist, das in an sich bekannter Weise aus Piezofolien eines Quarzmaterials mit einer geeigneten Kristallstruktur aufgebaut ist, so dass unter Ausnutzung des sogenannten Piezoeffekts bei Anlage einer äußeren elektrischen Spannung an hier nicht dargestellte Elektroden eine mechanische Reaktion des Piezoaktors 1 in Form einer axialen Bewegung erfolgt.

Der Piezoaktor 1 ist an seinem festen Ende mit einem Fußteil 3 aus Stahl oder Keramik zentriert und fest verbunden. Auf dem Fußteil 3 ist eine deformierbare und gut wärmeleitende Hülse 4 aufgesetzt und z.B. durch Schweißen mit dem Fußteil 3 verbunden. Die Hülse 4 weist im Bereich des Fußteils 3 einen geringeren Durchmesser auf, da die Hülse 4 beim Einpressvorgang in eine Haltebohrung 5 in diesem Bereich durch das Fußteil 3 nicht radial nachgeben kann. Die Hülse 4 ist z. B. aus Kupfer, Stahl oder einem Kunststoff gefertigt und kann dabei so lang sein wie das gesamte Piezoelement 2 oder aber kürzer, um nur die Verbindung zwischen dem Piezoelement 2 und dem Fußteil 3 zu versteifen.

Das Piezoelement 2 ist in der Hülse 4 mit einem wärmeleitfähigen Elastomer 6 vergossen. Über eine Verjüngung 7 in der Haltebohrung 5, z.B. in einem Ventilgehäuse 8, wird diese Bauteilkombination in die Haltebohrung 5 eingepresst, wobei die Hülse 4 gegenüber der Haltebohrung 5 im Ventilgehäuse 8 nur ein geringes Übermaß aufweist, so dass Fertigungstoleranzen am Gehäuse 8 und der Hülse 4 ausgeglichen werden können und sich zwischen dem Gehäuse 8 und der Hülse 4 eine gute Wärmeleitung einstellt.

Auf dem bewegten Ende des Piezoaktors befindet sich ein Kopfteil mit Druckbolzen 9, das entweder mit dem Piezoelement 2 fest verbunden ist oder nur aufliegt und über eine Feder 10 den Piezoaktor 1 so verspannt, dass dieser im Betrieb nur Druckspannungen ausgesetzt wird. Der Kraftschluss verläuft hier über eine Fixierscheibe 11 und einen Sicherungsring 12 in das Ventilgehäuse 8 und zurück über das Fußteil 3 in das Piezoelement 2.

Zwischen dem Elastomer 6 und der Hülse 4 auf der einen Seite und dem Kopfteil 9 auf der anderen Seite ist ein Spalt 13 ausgebildet, der dem Ausgleich von Wärmedehnung und Verformung beim Einpressvorgang dient. Die Zentrierung des Piezoaktors 1 erfolgt nun über die Hülse 4 und nicht über das Fußteil 3.

Die Hülse 4 kann an das Fußteil 3 beispielsweise angelötet, angeschweißt, geklebt oder nach den anhand von Figuren 2 bis 4 beschriebenen Verfahren befestigt werden. Dabei ist nach der Figur 2 am Umfang des Fußteils 3 eine Rändelung 14 aufgebracht auf die die Hülse 4 formschlüssig aufgepresst wird. Beim Ausführungsbeispiel nach der Figur 3 ist die Hülse 4 als ein Tiefziehteil mit einem Deckel 15 dargestellt, auf den das Fußteil 3 montiert wird. In diesem Fall läuft der Kraftfluss im Betrieb vom Piezoelement 2 über den Deckel 15 der Hülse 4 in das Ventilgehäuse 8. Aus. der Figur 4 ist als weitere Befestigungsvariante eine umlaufende Nut 16 im Fußteil 3 vorgesehen, in die die Hülse 4 eingebördelt ist.

Bei einem Ausführungsbeispiel nach Figur 5 ist das Piezoelement 2 mit Zentrierring 17 versehen, der auf dem Fußteil 3 aufliegt. Der Zentriering 17 ist so ausgeführt, dass er ein Luftvolumen einschließt und bei Wärmedehnung des Elastomers 6 von diesem zusammengedrückt werden kann.

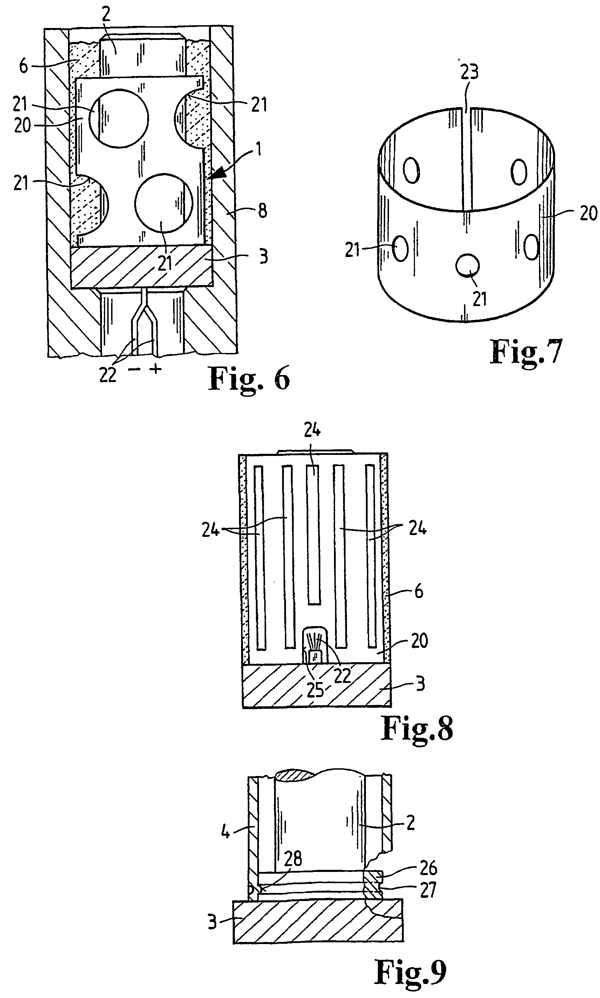

In Figur 6 ist ein Ausführungsbeispiel des Piezoaktors 1 gezeigt, der eine Hülse 20 mit Ausnehmungen, d.h. hier Löcher 21 oder zusätzliche senkrechte Schlitze, aufweist. Auf der unteren Seite des Fußteils 3 treten die elektrischen Anschlüsse 22 für das Piezoelement 2 hervor, die durch das Fußteil 3 hindurch geführt sind. Auch hier sind das Piezoelement 2, die Hülse 20 und das Fußteil 3 im Gehäuse 8 montiert und von einem wärmeleitfähigen Elastomer 6 umgeben, welches entweder vor der Montage in einer Gießform diese Bauelemente umgibt oder erst im montierten Zustand in das Gehäuse 8 gegossen wird. Dieses Elastomer 6 dient der Ableitung der in Wärme umgewandelten Verlustenergie des Piezoelements 2 im Betrieb zum Gehäuse 8 hin. Figur 7 zeigt eine abgewandelte Form der Hülse 20 mit einem senkrechten Schlitz 23.

Aus Figur 8 ist eine Variante der Ausbildung der Hülse 21 mit Längsschlitzen 24 zu entnehmen. Weiterhin ist hier eine Aussparung 25 für die elektrischen Anschlüsse 22 des Piezoelements 2 vorhanden.

Beim Ausführungsbeispiel nach Figur 9 wird eine weitere mögliche Verbindung des Fußteils 3 mit der Hülse 4 oder 20 gezeigt. Das Piezoelement 2 ist zentriert auf das Fußteil 3 aufgesetzt, wobei im Fußteil 3 in einem Absatz 26, der zur Aufnahme der Hülse 4 oder 20 dient, eine Nut 27 eingebracht ist, in die ein umlaufender Wulst 28 am Innendurchmessser der Hülse 4 oder 20 eingeklinkt wird und so die beiden Bauteile miteinander verbindet.

## Patentansprüche

1. Piezoaktor mit mindestens einem Piezoelement (2) zur Beaufschlagung eines Betätigungselements mit einer Zug- oder Druckkraft und mit einem Pußteil (3), an dem das Piezoelement (2) befestigt ist und über das das Piezoelement (2) unter einer mechanischen Vorspannung in einem Gehäuse (8) zentriert gehalten ist, wobei am Fußteil (3) eine Hülse (4, 20) befestigt ist, die das Piezoelement (2) zumindest in Teilbereichen elektrisch von diesem isoliert, mechanisch stabilisierend umschließt, **dadurch gekennzeichnet, dass** die Hülse (4, 20) mit dem Piezoelement (2) in eine entsprechende Haltebohrung (5) des Gehäuses (8) für den Piezoaktor (1) fest, gegebenenfalls über eine schräge Schulter (7) am Rand der Haltebohrung (5), eingepresst ist.

2. Piezoaktor nach Anspruch 1, **dadurch gekennzeichnet, dass**
- zwischen die Hülse (4;20) und das Piezoelement (2) ein wärmeleitendes Elastomer (6) eingebracht ist.

3. Piezoaktor nach Anspruch 1 oder 2, **dadurch gekennzeichnet, dass**
- die Hülse (4;20) aus einem wärmeleitfähigen und in vorgegebenen Grenzen verformbaren Material besteht.

4. Piezoaktor nach Anspruch 3, **dadurch gekennzeichnet, dass**
- die Hülse (4;20) aus Metall, vorzugsweise Kupfer oder Stahl ist.

5. Piezoaktor nach Anspruch 3, **dadurch gekennzeichnet, dass**
- die Hülse (4;20) aus Kunststoff ist.

6. Piezoaktor nach einem der vorhergehenden Ansprüche, **dadurch gekennzeichnet, dass** die Hülse (20) in ihrer Wand Ausnehmungen (21, 23, 24, 25), vorzugsweise Löcher (21) oder Längsschlitze (24) aufweist.

7. Piezoaktor nach einem der vorhergehenden Ansprüche, **dadurch gekennzeichnet, dass** das Fußteil (3) eine umlaufende Nut (27) aufweist, in die ein ebenfalls umlaufender Wulst (28) am Innendurchmesser der Hülse (4, 20) einklinkbar ist.

8. Piezoaktor nach einem der vorhergehenden Ansprüche, **dadurch gekennzeichnet, dass** zwischen das Piezoelement (2) und die Hülse (4, 20) Zentrierringe (17) eingebracht sind.

9. Piezoaktor nach einem der Ansprüche 6 bis 8, **dadurch gekennzeichnet, dass** nach dem Einbringen des Piezoelements (2) mit der Hülse (20) in eine Haltebohrung (5) des Gehäuses (8) für den Piezoaktor (1) die verbleibenden Zwischenräume in der Haltebohrung (5) zumindest teilweise mit einem wärmeleitenden Elastomer (6) ausfüllbar sind.

## Claims

1. Piezo actuator having at least one piezo element (2) for subjecting an actuating element to a tensile or compressive force and having a foot part (3) to which the piezo element (2) is secured and by means of which the piezo element (2) is kept centred in a housing (8) under a mechanical prestress, a sleeve (4, 20) being secured to the foot part (3) and enclosing the piezo element (2) in such a way as to stabilize it mechanically, at least in partial regions that are electrically insulated from the piezo element, **characterized in that** the sleeve (4, 20) together with the piezo element (2) is press-fitted firmly into a corresponding retaining bore (5) in the housing (8) for the piezo actuator (1), if appropriate by means of an oblique shoulder (7) on the periphery of the retaining bore (5).

2. Piezo actuator according to Claim 1, **characterized in that**
- a heat-conducting elastomer (6) is introduced between the sleeve (4; 20) and the piezo element (2).

3. Piezo actuator according to Claim 1 or 2, **characterized in that**
- the sleeve (4; 20) consists of a heat-conducting material that is deformable within predetermined limits.

4. Piezo actuator according to Claim 3, **characterized in that**
- the sleeve (4; 20) is made of metal, preferably copper or steel.

5. Piezo actuator according to Claim 3, **characterized in that**
- the sleeve (4; 20) is made of plastic.

6. Piezo actuator according to one of the preceding claims, **characterized in that** the sleeve (20) has recesses (21, 23, 24, 25), preferably holes (21) or elongated slots (24), in its wall.

7. Piezo actuator according to one of the preceding claims, **characterized in that** the foot part (3) has an encompassing groove (27), into which a likewise encompassing bead (28) on the inside diameter of the sleeve (4, 20) can be made to engage.

8. Piezo actuator according to one of the preceding claims, **characterized in that** centring rings (17) are introduced between the piezo element (2) and the sleeve (4, 20).

9. Piezo actuator according to one of Claims 6 to 8, **characterized in that**, after introducing the piezo element (2) together with the sleeve (20) into a retaining bore (5) in the housing (8) for the piezo actuator (1), the remaining interstices in the retaining bore (5) can be filled at least partially with a heat-conducting elastomer (6).

## Revendications

1. Actionneur piézo-électrique comprenant au moins un piézo-élément (2) pour actionner un élément de manoeuvre par une force de traction ou de pression, et une partie de pied (3) sur laquelle est fixé le piézo-élément (2) et par laquelle il est maintenu centré par une précontrainte mécanique dans un boîtier (8), tandis qu'une douille (4, 20) fixée sur la partie de pied (3), isole électriquement de cette partie de pied le piézo-élément au moins dans des zones partielles et l'entoure en le stabilisant mécaniquement,
**caractérisé en ce que**
la douille (4, 20) avec le piézo-élément (2) est enfoncée à force dans un alésage de maintien (5) du boîtier (8) de l'actionneur piézo-électrique (1), le cas échéant par l'intermédiaire d'un épaulement oblique (7) prévu sur le bord de l'alésage de maintien (5).

2. Actionneur piézo-électrique selon la revendication 1,
**caractérisé en ce que**
un élastomère (6) conducteur de la chaleur est monté entre la douille (4, 20) et le piézo-élément (2).

3. Actionneur piézo-électrique selon la revendication 1 ou 2,
**caractérisé en ce que**
la douille (4, 20) est faite d'un matériau conducteur de la chaleur et déformable dans des limites prédéfmies.

4. Actionneur piézo-électrique selon la revendication 3,
**caractérisé en ce que**
la douille (4, 20) est en métal, de préférence du cuivre ou de l'acier.

5. Actionneur piézo-électrique selon la revendication 3,
**caractérisé en ce que**
la douille (4, 20) est en matière plastique.

6. Actionneur piézo-électrique selon une des revendications précédentes,
**caractérisé en ce que**
la douille (4, 20) présente dans sa paroi des évidements (21, 23, 24, 25), de préférence des trous (21) ou des fentes allongées (24).

7. Actionneur piézo-électrique selon une des revendications précédentes,
**caractérisé en ce que**
la partie de pied (3) présente une rainure périphérique (27) dans laquelle peut être encliqueté un bourrelet également périphérique (28) situé sur la paroi interne de la douille (4, 20).

8. Actionneur piézo-électrique selon une des revendications précédentes,
**caractérisé en ce que**
des bagues de centrage (17) sont montées entre le piézo-élément (2) et la douille (4, 20).

9. Actionneur piézo-électrique selon une des revendications 6 à 8,
**caractérisé en ce que**
après mise en place du piézo-élément (2) avec la douille (20) dans un alésage de maintien (5) du boîtier (8) de l'actionneur piézo-électrique (1), les espaces intermédiaires subsistant dans l'alésage de maintien (5) peuvent être remplis au moins partiellement par un élastomère (6) conducteur de la chaleur.
